# EUROPÄISCHE PATENTSCHRIFT

(11) **EP 0 768 740 B1**
(45) Veröffentlichungstag und Bekanntmachung des Hinweises auf die Patenterteilung: **12.05.1999**
(21) Anmeldenummer: 96114847.5
(22) Anmeldetag: 16.09.1996
(51) Int. Cl.: H01S 3/085, G02F 1/313, G02B 6/34

(54) **Optoelektronisches Bauelement mit kodirektionaler Modenkopplung**
Optoelectronic element with codirectional mode coupling
Elément optoélectronique avec couplage de mode codirectionnel

(30) Priorität: 13.10.1995 DE 19538232
(43) Veröffentlichungstag der Anmeldung: 16.04.1997
(73) Patentinhaber: SIEMENS AKTIENGESELLSCHAFT, 80333 München (DE)
(72) Erfinder: Amann, Markus-Christian, Prof.-Dr., 34225 Baunatal (DE); Illek, Stefan, Dr., 83260 Feldkirchen-Westerham (DE)

(56) Entgegenhaltungen:
- EP-A- 0 552 390
- I.E.E.E. JOURNAL OF SELECTED TOPICS IN QUANTUM ELECTRONICS, Bd. 1, Nr. 2, 1.Juni 1995, Seiten 387-395, XP000521102 AMANN M -C ET AL: "DISTRIBUTED FORWARD COUPLED (DFC) LASER"
- ELECTRONICS LETTERS, Bd. 32, Nr. 3, 1.Februar 1996, Seite 221/222 XP000554952 AMANN M -C ET AL: "WIDELY TUNABLE LASER DIODES WITH TAPERED INDEX PERTURBATIONS FOR REDUCED INTERNAL REFLECTIONS AND IMPROVED WAVELENGTH ACCESS"

## Beschreibung

Elektronisch abstimmbare integrierte Laserdioden mit einem großen Abstimmbereich, d. h. größer als ca. 1% der Wellenlänge, sind Schlüsselkomponenten für vielfache Anwendungen in der optischen Kommunikationstechnik. Unter den bisher bekannten Ausführungen solcher Laserdioden sind diejenigen mit kodirektionaler Modenkopplung vorteilhaft, da sie nur einen einzigen Abstimmstrom benötigen. Derartige Laserdioden sind z. B. beschrieben in den Veröffentlichungen von I. Kim et al.: "Broadly tunable vertical-coupler filtered tensile-strained InGaAs/InGaAsP multiple quantum well laser" in Appl. Phys. Lett. 64, 2764 bis 2766 (1994) und von M.-C. Amann et al.: "Widley Tunable Distributed Forward Coupled (DFC) Laser" in Electr. Lett. 29, 793 bis 794 (1993).

Bei der kodirektionalen Modenkopplung werden zwei in die gleiche Richtung laufende Wellen bzw. transversale Moden über ein Gitter miteinander gekoppelt. Diese Kopplung ist wellenlängenselektiv und strom- oder spannungsabstimmbar, so daß in Abhängigkeit des Abstimmstroms bzw. der Abstimmspannung die in äquidistanten Wellenlängenintervallen angeordneten longitudinalen Lasermoden einzeln zum Anschwingen gebracht werden können. Aufgrund der periodischen Inhomogenitaten, die durch die Gitterstruktur in den Laserresonator eingebracht werden, entstehen jedoch zusätzlich störende Rückreflexionen (kontradirektionale Kopplung). Je nach Wellenlänge und Phasenlage kann hierdurch bei jedem longitudinalen Mode unterschiedlich eine konstruktive oder destruktive Interferenz entstehen. Als Folge hieraus und aufgrund der relativ schwachen Wellenlängenselektivität der kodirektionalen Modenkopplung lassen sich daher zumeist nicht alle möglichen longitudinalen Lasermoden einzeln selektieren, so daß in der Praxis nur eine geringe Anzahl diskreter Wellenlängen innerhalb des Abstimmbereichs verfügbar sind. Filtereigenschaften und Spektralverteilung sind für diese Laser bisher ohne Berücksichtigung interner Rückreflexionen untersucht worden. Demgemäß war die theoretisch berechenbare Modenselektion und Seitenbandunterdrückung für die Mehrzahl longitudinaler Moden bisher nicht erreichbar (s. die zitierten Veröffentlichungen).

In der EP 0 552 390 A1 ist eine abstimmbare Laserdiode beschrieben, bei der kodirektionale Modenkopplung durch eine periodisch unterbrochene, parallel zu zwei Wellenleiterschichten angeordnete Absorberschicht bewirkt ist. An den longitudinalen Berandungen der einzelnen Abschnitte dieser Absorberschicht treten jeweils Sprünge in dem Realteil des effektiven Brechungsindexes in den Wellenleiterschichten auf. Die internen Rückreflexionen treten daher bei dieser Laserdiode in periodischen Abständen auf.

In der EP 0 411 816 A2 ist die Herstellung von Wellenleiter-Tapers, die sich in vertikaler Richtung verjüngen, beschrieben. Der Wellenleiter wird durch eine Vielzahl von InGaAsP-Schichten mit dazwischenliegenden InP-Ätzstoppschichten gebildet. Der Taper wird durch stufenweises Ätzen dieser Schichtstruktur hergestellt.

Laserdioden mit gewinngekoppelter Gitterstruktur sind beschrieben in US 5,208,824, DE 44 29 586 A1, US 5,452,318, US 5,143,864, US 5,093,835 und in der Veröffentlichung von A. Rast et al.: "Gain-Coupled Strained Layer MQW-DFB Lasers with an Essentially Simplified Fabrication Process for λ = 1.55 µm" in IEEE Photonics Technology Letters 7, 830 - 832 (1995).

Aufgabe der vorliegenden Erfindung ist es, ein optoelektronisches Bauelement mit kodirektionaler Modenkopplung anzugeben, bei dem unerwünschte interne Rückreflexionen der geführten Moden nach Möglichkeit unterbunden sind.

Diese Aufgabe wird mit dem Bauelement mit den Merkmalen des Anspruches 1, 2 bzw. 3 gelöst. Weitere Ausgestaltungen ergeben sich aus den abhängigen Ansprüchen.

Die vorliegende Erfindung löst das Problem dadurch, daß an den Stellen, an denen bei herkömmlichen Bauelementen mit kodirektionaler Modenkopplung Sprünge des Brechungsindexes auf treten, in oder an den für diese Sprünge verantwortlichen Schichten oder Schichtstrukturen taperartige Verjüngungen, d. h. graduelle Änderungen der seitlichen oder vertikalen Abmessungen, oder gradierte Zusammensetzungen der Halbleiter-Mischkristalle vorhanden sind. Durch diese erfindungsgemäßen Maßnahmen werden die Sprünge in dem Brechungsindex durch stetige oder zumindest mehrfach abgestufte Übergänge ersetzt. Die über die gesamte Länge dieser stetigen Übergänge hin partiell reflektierten Wellen interferieren destruktiv, weswegen keine oder nur geringe Reflexionen auftreten. Die kodirektionale Kopplung in Vorwärtsrichtung wird dagegen nur geringfügig beeinflußt. An den Grenzen zwischen Bereichen unterschiedlicher Materialien, die in der Ausbreitungsrichtung der Moden in einem die Kopplung bewirkenden Gitter aufeinanderfolgen, kann die allmähliche Zunahme der lateralen Abmessungen dieser Bereiche z. B. dadurch erreicht sein, daß diese Grenzen im Gitter nicht im rechten Winkel zur Ausbreitungsrichtung der Moden angeordnet werden, sondern schräg dazu. Man erhält auf diese Weise eine taperartig in Richtung des Wellenleiters verjüngte Strukturierung der Gitterschicht. Bei einer periodischen Absorberschicht kann z. B. jede Berandung oder Grenzfläche eines Abschnittes dieser Absorberschicht, die quer zur Ausbreitungsrichtung der Moden verläuft, einen Taper dieses Abschnittes bilden. Bei einem durch Riffelungen oder periodische Dickeschwankungen in einer durchgehenden Schicht ausgebildeten Gitter wird erfindungsgemäß diese Riffelung oder andersartige periodische Strukturierung schräg zur Ausbreitungsrichtung der Moden hin ausgerichtet, falls die Sprünge im Realteil des effektiven Brechungsindexes in der Ausbreitungsrichtung unerwünscht sind. Falls die Kopplung durch die periodische Änderung des Realteils des effektiven Brechungsindexes erfolgt, wird eine taperartige Aufweitung bzw. Verjüngung z. B. nur an den in der Ausbreitungsrichtung der Moden vorderen und hinteren Rändern der Gitterschicht vorgesehen. Diese Ränder verlaufen z. B. schräg zur Ausbreitungsrichtung der Moden, während das Gitter selbst in herkömmlicher Weise strukturiert wird. Als Alternative besteht die Möglichkeit, eine stetige Änderung des Brechungsindexes durch eine gradierte Änderung der Zusammensetzung des Halbleiter-Mischkristalles eines für die betreffende Schicht verwendeten quaternären oder ternären Halbleitermateriales einzusetzen. Es folgt eine genauere Beschreibung dieser Erfindung anhand der beigefügten Figuren.
- Figur 1: zeigt die für die Struktur des Bauelementes wesentlichen Komponenten im Schema.
- Figur 2: zeigt einen Ausschnitt aus Figur 1b.
- Figuren 3 und 4: zeigen Querschnitte durch ein herkömmliches Bauelement, bei dem die erfindungsgemäße Modifikation verwendbar ist.
- Figur 5: zeigt eine alternative Ausgestaltung des Bauelementes entsprechend Figur 1.

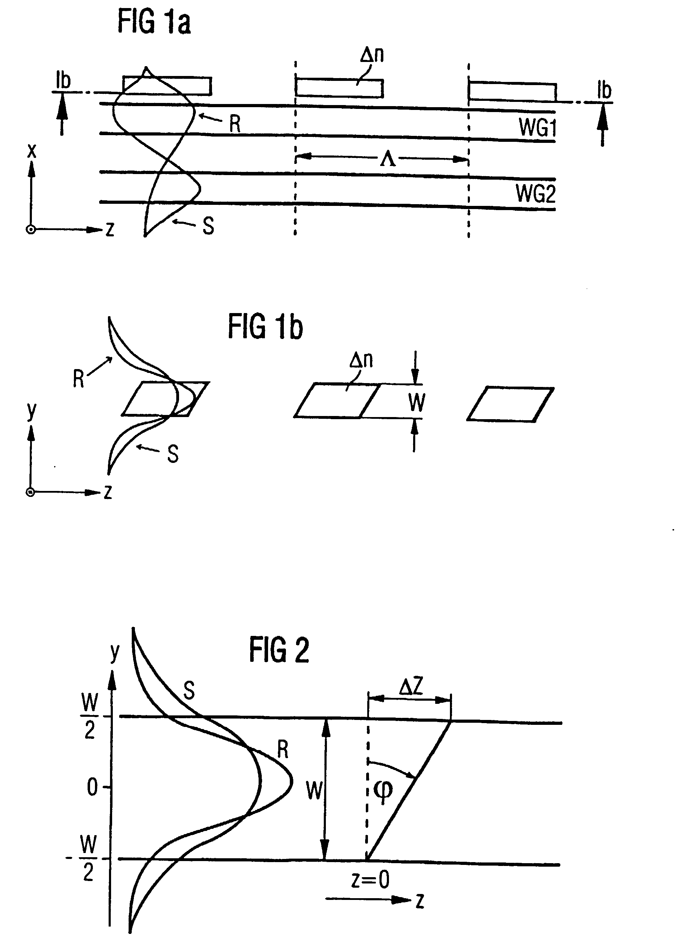

Figur 1 zeigt eine typische Anordnung zweier Wellenleiterschichten WG1, WG2 und einer periodisch strukturierten Schicht Δn, mit der die kodirektionale Kopplung hervorgerufen wird. In Figur 1a ist die Seitenansicht, in Figur 1b die Ansicht in der in Figur 1a eingezeichneten Blickrichtung dargestellt. Infolge der periodischen Änderung des Brechungsindexes als Auswirkung der periodisch strukturierten Schicht (Filterschicht oder Absorberschicht) werden die in den Wellenleiterschichten mit WG1, WG2 geführten Moden bei einer Wellenlänge verkoppelt, die gleich dem Produkt ist aus der Periode Λ und der Differenz des Realteiles des effektives Brechungsindexes der beiden Moden. An den Berandungen der einzelnen Abschnitte Δn (Figur 1a) der periodisch strukturierten Schicht treten ohne die in Figur 1b dargestellten erfinderischen Maßnahmen unerwünschte Sprünge in dem effektiven Brechungsindex auf, falls die Ausbreitung (propagation) der Moden in Richtung der eingezeichneten z-Achse erfolgt. Wegen der Herstellungstoleranzen von mindestens 0,1 µm zeigen die verschiedenen Reflexionen an diesen Sprungstellen statistisch verteilte Phasenunterschiede, so daß wegen zufällig verteilter konstruktiver oder destruktiver Interferenzen ein Teil der longitudinalen Moden nicht verfügbar ist. Erfindungsgemäß sind daher entsprechend der Darstellung der Figur 1b die Berandungen der Anteile der Schicht Δn so abgeschrägt oder zugespitzt (Taper), daß in der Längsrichtung des Wellenleiters diese Anteile der Schicht Δn sich lateral allmählich aufweiten oder verengen und auf diese Weise eine stetige Änderung des Realteiles des effektiven Brechungsindexes in den Wellenleiterschichten bewirkt ist.

Ein Ausschnitt aus Figur 1b ist in Figur 2 gezeichnet. Die Moden pflanzen sich in Richtung der eingezeichneten z-Achse fort. Auf der rechten Seite ist ein Anteil der periodisch strukturierten Schicht Δn eingezeichnet, deren Rand mit der Senkrechten auf die Längsrichtung des Wellenleiters in der Schichtebene den Winkel ϕ einschließt. Es ergibt sich so eine Weglänge Δz, auf der der Realteil des effektiven Brechungsindexes eine kontinuierliche Änderung erfährt. Die Breite der Schicht Δn entspricht bei dieser Ausführungsform der Breite W der Wellenleiterschichten WG1, WG2. In Figur 2 sind die kodirektional gekoppelten Moden R, S auf der linken Seite durch die Amplituden ihrer Feldstärken eingezeichnet. Die Gesamtreflexion ergibt sich bei dieser Anordnung als Integral längs der Strecke Δz. Falls der auftretende Phasenunterschied 2k₀n_{z}Δz einer Mode mit effektivem Brechungsindex n_{z} und Wellenzahl k₀ = 2π/λ₀ größer als 2π ist, tritt bei der Integration eine Auslöschung der Reflexionsanteile durch starke destruktive Interferenz auf. Andererseits reduziert sich aber auch die kodirektionale Kopplung bei stetigen Übergängen der Brechungsindizes. Allerdings ist dieser Einfluß um ca. 2 Größenordnungen geringer, da hierbei nicht die Laufzeit bzw. Phasenlage der einzelnen Transversalmoden R oder S entscheidend ist, sondern es vielmehr auf die Laufzeit- bzw. Phasendifferenz der Moden beim Durchlaufen der Wegstrecke Δz ankommt. Daher existiert ein großer Wertebereich für Δz, innerhalb dessen einerseits destruktive Interferenz der Reflexion und Minderung der Gesamtreflexion auftritt, andererseits aber die kodirektionale Modenkopplung noch nicht spürbar beeinträchtigt wird. Für mögliche Werte von Δz ergibt sich daher ein Bereich zwischen der halben Wellenlänge des Lasers im Vakuum, dividiert durch den mittleren effektiven Brechungsindex der Transversalmoden R und S, und der viertel Wellenlänge des Lasers im Vakuum, dividiert durch die Differenz der effektiven Brechungsindizes der Moden. Typische Werte sind z. B. 1,55 µm für die Vakuumwellenlänge, 3,3 für den mittleren effektiven Brechungsindex und 0,1 für die Differenz der effektiven Brechungsindizes der Moden bei einer InGaAsP-Laserdiode. Damit erhält man ein zulässiges Intervall für Δz von 0,25 µm bis 4 µm als typischen Wert. Beispielsweise errechnet sich bei einer Breite W der Wellenleiterstreifen von 2 µm und bei einem Winkel ϕ von 30° für die taperartige Schrägstellung der Grenzflächen der Anteile der strukturierten Schicht Δn eine Reduktion der Leistungsreflexion um einen Faktor 100 bis 10.000 je nach Stärke der seitlichen Wellenführung. Mit einer derart ausgeprägten Reflexionminderung ergibt sich eine entscheidende Verbesserung der Eigenschaften der Laserdiode.

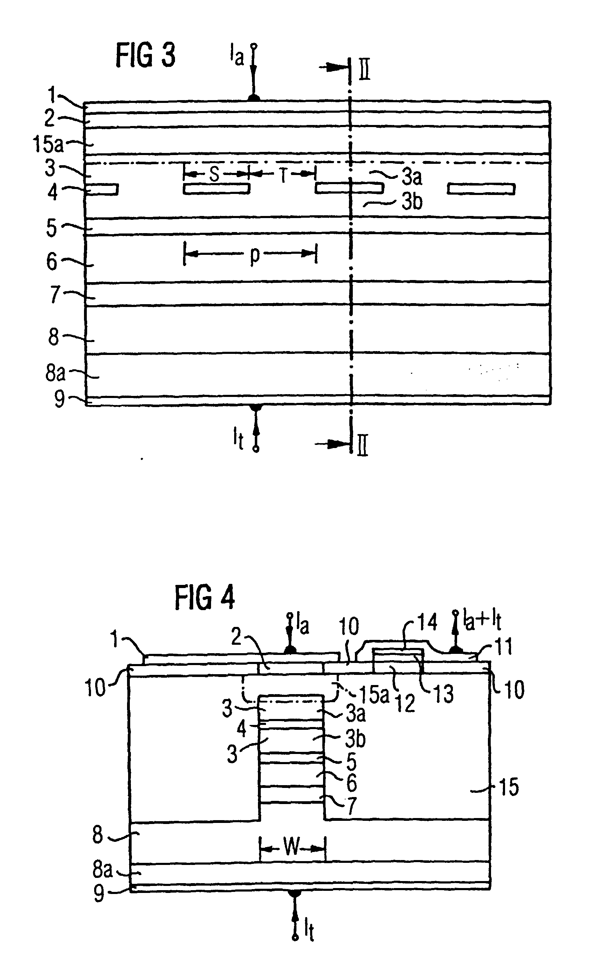

Eine mögliche Ausführungsform des Bauelementes als Laserdiode ist als Beispiel in den Figuren 3 und 4 dargestellt. In dem Längsschnitt der Figur 3 und dem dort eingezeichneten zugehörigen Querschnitt der Figur 4 sind die Wellenleiterschichten 5, 7 vertikal zueinander und zu einer periodisch unterbrochenen Absorberschicht 4 angeordnet. Auf dem Substrat 8a, dessen Dicke hier nicht im Maßstab gezeichnet ist, befinden sich übereinander eine Mantelschicht 8, die z. B. wie das Substrat p-leitend dotiert ist, die untere Wellenleiterschicht 7, eine Zwischenschicht 6, die obere Wellenleiterschicht 5, die Absorberschicht 4, die zwischen oberen und unteren Anteilen 3a, 3b einer ebenfalls für p-Leitung dotierten Mantelschicht angeordnet ist, und ggf. eine Kontaktschicht 2. Mit 15a ist ein Anschlußbereich, der hoch p-leitend dotiert ist, als oberer Anteil der lateralen Mantelschicht 15 (s. Figur 4) bezeichnet. Die Zwischenschicht 6 ist entgegengesetzt, also n-leitend dotiert. Die Anteile der Absorberschicht der Länge S mit der daran sich anschließenden Unterbrechung der Länge T bilden zusammen eine Periode P der periodischen Strukturierung. Kontakte 1, 9 und 11 dienen dem elektrischen Anschluß. Die laterale Mantelschicht 15 ist n-leitend dotiert und stellt die leitende Verbindung zwischen der Zwischenschicht 6 und dem lateralen Kontakt 11 über eine weitere Zwischenschicht 12, eine Ätzstoppschicht 13 und eine hoch n-leitend dotierte Kontaktschicht 14 her. Die Ströme Iₐ zur Erzeugung der Laserstrahlung und Iₜ zur Abstimmung sind ebenfalls eingezeichnet. In Figur 4 ist erkennbar, daß die Wellenleiterschichten 5, 7 und die Absorberschicht 4 eine eingebettete stegartige Struktur der Breite W bilden. Diese Laserdiode hat die Struktur einer TTG-Laserdiode (Tunable Twin Guide), wie sie in der angegebenen DE 92 100 886 beschrieben ist. Die jeweiligen Abschnitte der Absorberschicht 4 sind hier erfindungsgemäß entsprechend Figur 1b bzw. Figur 2 abgeschrägt, so daß die Grenzflächen oder Berandungen der Anteile der Absorberschicht 4 in Aufsicht schräg zur Längsrichtung des Wellenleiters verlaufen.

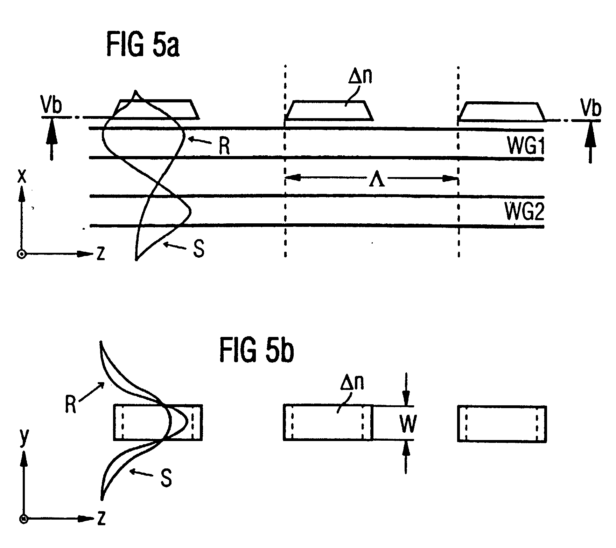

Eine alternative Möglichkeit für die sich verjüngenden Enden der die Kopplung bewirkenden periodischen Struktur ergibt sich dadurch, daß entsprechend der Darstellung in Figur 5 die taperförmige Zuspitzung oder Verjüngung der Abschnitte der Schicht Δn in der Vertikalen entsprechend Figur 5a vorhanden ist. Ein solcher vertikaler Taper läßt sich z. B. mittels Trockenätzens unter zeitlich veränderlichem Winkel unter Verwendung einer Schattenmaske (im Abstand zu der zu ätzenden Schicht) herstellen. Eine andere Möglichkeit ist in der eingangs erwähnten EP 0 411 816 beschrieben. In Figur 5b sind entsprechend der in Figur 5a eingezeichneten Blickrichtung die Schichtanteile der Schicht Δn mit den verdeckten Konturen der oberen Begrenzungen dieser Taper (strichpunktierte Linien) eingezeichnet. Bei dieser Ausgestaltung sind also die Grenzflächen der Schicht Δn in einem Winkel zur Ausbreitungsrichtung der Moden ausgerichtet, der senkrecht zur Schichtebene von einem rechten Winkel verschieden ist. Anders ausgedrückt, schließen die z-Achse (s. Figur 5b) und eine Normale auf eine solche Grenzflache einen Winkel ein, dessen senkrechte Projektion in eine senkrecht auf der Schichtebene stehende Ebene von 0° bzw. 180° verschieden ist. Im Fall der Ausführungsform der Figur 1 sind die Grenzflächen der Schicht Δn in einem in der Schichtebene von einem rechten Winkel verschiedenen Winkel zu der Ausbreitungsrichtung der Moden ausgerichtet, d. h. die z-Achse (s. Figur 1b) und eine Normale auf diese Grenzfläche schließen einen Winkel ein, dessen bezüglich der Schichtebene senkrechte Projektion in die Schichtebene nicht 90° ist. Hierbei ist jeweils der Fall eingeschlossen, daß taperartige Verjüngungen sowohl in lateraler als auch in vertikaler Richtung vorhanden sind. Es können also die Ausführungsformen der Figuren 1 und 5 miteinander kombiniert sein. Die besagte Grenzfläche muß keine ebene Fläche sein, sondern kann z. B. gewölbt oder an den Kanten abgerundet sein. Die in Figur 1b in Aufsicht gezeigte Berandung eines Anteiles der Schicht Δn muß nicht wie eingezeichnet geradlinig sein, sondern kann in einer geeigneten Weise gerundet oder z. B. s-förmig geschwungen sein.

Eine Alternative des erfindungsgemäßen Bauelementes ist dadurch gegeben, daß die Halbleitermaterialien, aus denen z. B. bei der Ausführungsform der Figuren 3 und 4 die Absorberschicht 4 bzw. das diese Schicht umgebende Material der Mantelschicht 3 bestehen, an den Stellen, an denen kein Sprung des Brechungsindexes auftreten soll, gradiert zusammengesetzt sind. Falls die Absorberschicht 4 in Figur 3 InGaAs ist, kann die Mantelschicht 3 InP oder zumindest in zwischen den Anteilen dieser Absorberschicht 4 angeordneten Bestandteilen InGaAsP sein. Die Zusammensetzung der Halbleiter-Mischkristalle kann dann so vorgenommen werden, daß sich ein gradueller Übergang zwischen dem Material der Mantelschicht 3 und den Anteilen der Absorberschicht 4 ergibt. Als Folge der gradierten Zusammensetzung der Halbleitermaterialien ergibt sich eine entsprechende allmähliche Änderung des effektiven Brechungsindexes.

Ein mögliches Herstellungsverfahren nützt die von der Breite der Maskenöffnung abhängende unterschiedliche Wachstumsrate der den Mischkristall zusammensetzenden Halbleitermaterialien aus. Bei Verwendung einer Maske mit schlitzförmiger Öffnung, die sich zum Rand der Maske hin weitet, erhält man beim epitaktischen Aufwachsen im Bereich der schlitzförmigen Öffnung eine höhere Wachstumsrate, die nach außen hin stetig bis zur Wachstumsrate auf unmaskierten Flächen abnimmt. Abgesehen von einer vertikalen Verjüngung und einer der Form der Maskenöffnung entsprechenden lateralen Verbreiterung (Taper) erhält die aufgewachsene Schicht im Bereich der Aufweitung der Maskenöffnung eine Gradierung in der Zusammensetzung des Halbleiter-Mischkristalls.

Die Ausführungsform der Figur 5 kann wie angegeben speziell so ausgestaltet sein, daß die periodisch strukturierte Schicht Δn mehrere Schichten, die vertikal übereinander angeordnet sind und in ihrer Gesamtheit die Schicht Δn bilden, umfaßt. Diese Schichten können voneinander differierende Materialzusammensetzungen besitzen und außerdem durch dünne Ätzstoppschichten voneinander getrennt sein. Eine solche mehrlagige Schichtstruktur ermöglicht es, durch stufenweises Ätzen der sich verjüngenden Abschnitte der Schicht Δn nicht nur die in Längsrichtung des Wellenleiters auftretenden Änderungen der vertikalen Abmessung zu erhalten, sondern zusätzlich mehrfach gestufte Änderungen des Brechungsindexes durch die stufenweise Anordnung von Schichten mit unterschiedlicher Materialzusammensetzung zu erhalten. Eine Kombination der lateral variierenden Abmessung der Schicht Δn wie in dem Ausführungsbeispiel der Figur 1 mit einer variierenden Materialzusammensetzung in Längsrichtung des Wellenleiters ist ebenfalls möglich.

Das hier anhand der Ausführungsbeispiele beschriebene Prinzip kann an allen Stellen in einem Bauelement mit kodirektionaler Kopplung angewendet werden, an denen unstetige Änderungen des effektiven Brechungsindexes vermieden werden sollen. Das kann z. B. der Fall sein bei Übergängen zwischen aktiven und passiven Bereichen des Bauelementes. Eine Ausgestaltung, wie sie oben für jeden Anteil der periodisch strukturierten Schicht (Δn bzw. 4) beschrieben wurde, kann z. B. nur an Berandungen eines für die Kopplung vorgesehenen Gitters vorhanden sein. Die in Ausbreitungsrichtung der Moden vorhandenen Ränder des Gitters sind dann z. B. schräg zu dieser Ausbreitungsrichtung angeordnet. Die längs des Gitters vorgesehenen und erwünschten Unstetigkeiten im Brechungsindex bleiben davon unbeeinflußt. Auch dabei ist es möglich, die lateralen Begrenzungen des Gitters wie herkömmlich vorzunehmen, aber zwischen dem Gitter und dem in der Ausbreitungsrichtung der Moden angrenzenden Halbleitermaterial eine gradierte Zusammensetzung des Halbleitermateriales vorzusehen.

Zwischen den Anteilen der Absorberschicht 4 im Beispiel der Figur 3 bzw. der periodisch strukturierten Schicht Δn, die die Änderungen im effektiven Brechungsindex längs der Wellenleiterschichten hervorruft, können Anteile einer Kompensationsschicht vorgesehen sein, die den Realteil des effektiven Brechungsindexes nach Möglichkeit konstant halten. Die erfindungsgemäßen Mittel zur kontinuierlichen Anpassung des Brechungsindexes können dann in dieser Kompensationsschicht oder ggf. einer weiteren Schicht, die z. B. vertikal zu der periodisch strukturierten Schicht Δn angeordnet ist, vorhanden sein.

## Patentansprüche

1. Optoelektronisches Bauelement,
bei dem zwei Wellenleiterschichten (WG1, WG2, 5, 7) und eine Schicht (Δn, 4) mit einer periodischen Strukturierung vorhanden sind, die parallel zueinander angeordnet und so bemessen sind, daß zwischen in diesen Wellenleiterschichten geführten Moden (R,S) eine kodirektionale Kopplung bewirkt ist, dadurch gekennzeichnet, daß nicht für diese Kopplung erforderliche und daher unerwünschte Sprünge in den Realteilen der für eine Wellenführung dieser Moden maßgeblichen effektiven Brechungsindizes dadurch vermieden sind, daß in dieser periodisch strukturierten Schicht oder in einer weiteren Schicht stetige oder mehrfach abgestufte Änderungen der bezüglich der Schichtebenen lateralen oder vertikalen Abmessung oder der Materialzusammensetzung in der für die Ausbreitung der Moden vorgesehenen Richtung vorhanden sind.

2. Bauelement nach Anspruch 1,
bei dem eine stetige Änderung der lateralen Abmessung der periodisch strukturierten Schicht oder der weiteren Schicht dadurch bewirkt ist, daß eine quer zu der Ausbreitungsrichtung der Moden verlaufende Grenzfläche dieser betreffenden Schicht in einem in der Schichtebene von einem rechten Winkel verschiedenen Winkel (ϕ) zu dieser Ausbreitungsrichtung ausgerichtet ist.

3. Bauelement nach Anspruch 1,
bei dem eine stetige Änderung der vertikalen Abmessung der periodisch strukturierten Schicht oder der weiteren Schicht dadurch bewirkt ist, daß eine quer zu der Ausbreitungsrichtung der Moden verlaufende Grenzfläche dieser betreffenden Schicht in einem senkrecht zur Schichtebene von einem rechten Winkel verschiedenen Winkel zu dieser Ausbreitungsrichtung ausgerichtet ist.

4. Bauelement nach einem der Ansprüche 1 bis 3,
bei dem die periodisch strukturierte Schicht oder die weitere Schicht mindestens einen Bereich aufweist, in dem eine stetige oder mehrfach abgestufte Änderung des Realteiles des Brechungsindexes dadurch bewirkt ist, daß in diesem Bereich die über einen Querschnitt gemittelte Materialzusammensetzung der betreffenden Schicht in der für die Ausbreitung der Moden vorgesehenen Richtung entsprechend dieser Änderung variiert.

5. Bauelement nach einem der Ansprüche 1 bis 4,
bei dem die Wellenleiterschichten (WG1, WG2, 5, 7) vertikal zu den Schichtebenen parallel zueinander angeordnet sind,
bei dem durch eine zwischen diesen Wellenleiterschichten befindliche Zwischenschicht (6) eine getrennte Strominjektion in jede der beiden Wellenleiterschichten möglich ist,
bei dem vertikal zu den Schichtebenen parallel zu den Wellenleiterschichten eine in Längsrichtung der Wellenleiterschichten periodisch unterbrochene Absorberschicht (Δn, 4) angeordnet ist und
bei dem Abschnitte dieser Absorberschicht, die durch diese Unterbrechungen gebildet sind, in der Ausbreitungsrichtung der Moden eine stetige oder mehrfach abgestufte Änderung der bezüglich der Schichtebenen lateralen oder vertikalen Abmessungen oder der Materialzusammensetzung aufweisen.

6. Bauelement nach Anspruch 5,
bei dem in den Unterbrechungen zwischen den Abschnitten der Absorberschicht (Δn, 4) jeweils Abschnitte einer Kompensationsschicht (3) vorhanden sind, um die Realteile der effektiven Brechungsindizes längs der Wellenleiterschichten möglichst konstant zu halten.

7. Bauelement nach Anspruch 5 oder 6,
bei dem die Abschnitte der Absorberschicht in der Ausbreitungsrichtung der Moden laterale taperartige Verjüngungen oder Verbreiterungen aufweisen.

8. Bauelement nach Anspruch 6,
bei dem die Abschnitte der Absorberschicht (Δn, 4) ternäres Halbleitermaterial und die Abschnitte der Kompensationsschicht (3) quaternäres Halbleitermaterial sind und
bei dem zwischen einem Abschnitt der Absorberschicht und einem angrenzenden Abschnitt der Kompensationsschicht ein gradueller Übergang zwischen den Materialien dieser Abschnitte durch eine gradierte Zusammensetzung des Halbleiter-Mischkristalls bewirkt ist.

## Claims

1. Optoelectronic component, in which two waveguide layers (WG1, WG2,5,7) and a layer (Δn,4) with a periodic structuring are present, which are arranged parallel to one another and are dimensioned such that codirectional coupling is produced between modes (R,S) guided in these waveguide layers, characterized in that discontinuities, which are not required for this coupling and are therefore undesirable, in the real parts of the refractive indices which are decisively effective for wave guidance of these modes are avoided owing to the fact that there are present in this periodically structured layer, or in a further layer, continuous or multiply stepped changes in the dimension which is lateral with reference to the layer planes or vertical, or in the material composition in the direction provided for the propagation of the modes.

2. Component according to Claim 1, in which a continuous change in the lateral dimension of the periodically structured layer or the further layer is produced owing to the fact that a boundary, extending transverse to the direction of propagation of the modes, of this relevant layer is aligned with respect to this direction of propagation at an angle (ϕ) in the layer plane which differs from a right angle.

3. Component according to Claim 1, in which a continuous change in the vertical dimension of the periodically structured layer or the further layer is produced owing to the fact that a boundary, extending transverse to the direction of propagation of the modes, of this relevant layer is aligned with respect to this direction of propagation at an angle perpendicular to the layer plane which differs from a right angle.

4. Component according to one of Claims 1 to 3, in which the periodically structured layer or the further layer has at least one region in which a continuous or multiply stepped change in the real part of the refractive index is produced owing to the fact that in this region the material composition, averaged over a cross-section, of the relevant layer varies in accordance with this change in the direction provided for the propagation of the modes.

5. Component according to one of Claims 1 to 4, in which the waveguide layers (WG1, WG2,5,7) are arranged vertically with respect to the layer planes and parallel to one another, in which owing to an intermediate layer (6) located between these waveguide layers a separate current injection is possible into each of the two waveguide layers, in which an absorber layer (Δn, 4) periodically interrupted in the longitudinal direction of the waveguide layers is arranged vertically with respect to the layer planes and parallel to the waveguide layers, and in which sections of this absorber layer which are formed by these interruptions have in the direction of propagation of the modes a continuous or multiply stepped change in the lateral or vertical dimensions with respect to the layer planes or in the material composition.

6. Component according to Claim 5, in which sections of a compensation layer (3) are respectively present in the interruptions between the sections of the absorber layer (Δn, 4), in order as far as possible to keep the real parts of the effective refractive indices constant along the waveguide layers.

7. Component according to Claim 5 or 6, in which the sections of the absorber layer have lateral, taper-like narrowings or expansions in the direction of propagation of the modes.

8. Component according to Claim 6, in which the sections of the absorber layer (Δn, 4) are ternary semiconductor material and the sections of the compensation layer (3) are quaternary semiconductor material, and in which between a section of the absorber layer and an adjacent section of the compensation layer a gradual transition between the materials of these sections is produced by means of a graded composition of the semiconductor mixed crystal.

## Revendications

1. Elément optoélectronique,
dans lequel il y a deux couches de guides d'ondes (WG1, WG2, 5, 7) et une couche (Δn, 4) à structure périodique, qui sont disposées parallèlement les unes aux autres et dimensionnées de telle sorte qu'un couplage codirectionnel est obtenu entre des modes (R, S) guidés dans ces couches de guides d'ondes, caractérisé par le fait que des sauts, qui ne sont pas nécessaires à ce couplage et qui ne sont donc pas souhaités, des parties réelles de l'indice de réfraction effectif déterminant pour un guidage d'ondes de ces modes, sont évités par le fait qu'il y a dans cette couche à structure périodique ou dans une autre couche des variations continues ou à multiples degrés de la dimension latérale ou verticale par rapport au plan de couche ou de la composition de matériaux dans la direction prévue pour la propagation des modes.

2. Elément selon la revendication 1,
dans lequel une variation continue de la dimension latérale de la couche à structure périodique ou de l'autre couche est obtenue par le fait qu'une surface limite, s'étendant transversalement par rapport à la direction de propagation des modes, de la couche considérée est orientée par rapport à cette direction de propagation selon un angle (ϕ) différent de l'angle droit dans le plan de couche.

3. Elément selon la revendication 1,
dans lequel une variation continue de la dimension verticale de la couche à structure périodique ou de l'autre couche est obtenue par le fait qu'une surface limite, s'étendant transversalement par rapport à la direction de propagation des modes, de la couche considérée est orientée par rapport à cette direction de propagation selon un angle différent de l'angle droit perpendiculairement au plan de couche.

4. Elément selon l'une des revendications 1 à 3,
dans lequel la couche à structure périodique ou l'autre couche comporte au moins une zone dans laquelle une variation continue ou à multiples degrés de la partie réelle de l'indice de réfraction est obtenue par le fait que, dans cette zone, la composition de matériaux, considérée en moyenne sur la section transversale, de la couche considérée varie selon cette variation dans la direction prévue pour la propagation des modes.

5. Elément selon l'une des revendications 1 à 4,
dans lequel les couches de guides d'ondes (WG1, WG2, 5, 7) sont disposées parallèlement les unes aux autres et à la verticale des plans de couches,
dans lequel une couche intermédiaire (6) se trouvant entre ces couches de guides d'ondes permet une injection séparée de courant dans chacune des deux couches de guides d'ondes,
dans lequel une couche d'absorption (Δn, 4), interrompue périodiquement dans le sens de la longueur des couches de guides d'ondes, est disposée parallèlement aux couches de guides d'ondes et à la verticale des plans de couches, et
dans lequel des tronçons de cette couche d'absorption, qui sont formés par ces interruptions, présentent dans la direction de propagation des modes une variation continue ou à multiples degrés des dimensions latérale ou verticale par rapport aux plans de couches ou de la composition de matériaux.

6. Elément selon la revendication 5,
dans lequel, dans les interruptions entre les tronçons de la couche d'absorption (Δn, 4), il y a à chaque fois des tronçons d'une couche de compensation (3), afin de maintenir le plus possible constantes les parties réelles de l'indice de réfraction effectif le long des couches de guides d'ondes.

7. Elément selon la revendication 5 ou 6,
dans lequel les tronçons de la couche d'absorption comportent des rétrécissements ou des élargissements latéraux, dans la direction de propagation des modes, à la manière d'un raccord progressif.

8. Elément selon la revendication 6,
dans lequel les tronçons de la couche d'absorption (Δn, 4) sont en un matériau semi-conducteur ternaire et les tronçons de la couche de compensation (3) sont en un matériau semi-conducteur quaternaire, et
dans lequel, entre un tronçon de la couche d'absorption et un tronçon adjacent de la couche de compensation, une transition graduelle entre les matériaux de ces tronçons est obtenue par une composition graduelle du cristal mixte semi-conducteur.
